# FASCICULE DE BREVET EUROPEEN

(11) **EP 0 568 440 B1**
(45) Date de publication et mention de la délivrance du brevet: **15.10.1997**
(21) Numéro de dépôt: 93401086.9
(22) Date de dépôt: 27.04.1993
(51) Int. Cl.: H03K 17/30, G01R 19/165

(54) **Circuit de détection de seuils de tension**
Detektionsschaltung mit Spannungsschwellen
Detection circuit having voltage thresholds

(30) Priorité: 30.04.1992 FR 9205418
(43) Date de publication de la demande: 03.11.1993
(73) Titulaire: SGS-THOMSON MICROELECTRONICS S.A., 94250 Gentilly (FR)
(72) Inventeur: Fournel, Richard, Cabinet BALLOT-SCHMIT, F-75116 Paris (FR)
(74) Mandataire: Schmit, Christian Norbert Marie

(56) Documents cités:
- EP-A- 0 450 245
- FR-A- 2 254 792
- US-A- 3 733 498

## Description

L'invention concerne un circuit électronique de détection d'un niveau de tension inférieur ou supérieur à un seuil de tension donné, qui s'applique, notamment, aux circuits intégrés et tout particulièrement aux circuits intégrés dits sécurisés opérant sur des données confidentielles.

Il est utile de pouvoir autoriser ou interdire électroniquement l'utilisation d'un circuit intégré selon que le niveau de la tension d'alimentation reçu en entrée entre dans une plage définie et continue de valeurs ou n'entre pas dans cette plage. Une telle plage est typiquement délimitée par un seuil bas et un seuil haut. La fiabilité du circuit dépendant de ses conditions de fonctionnement, elle est perdue si la tension d'alimentation n'est plus dans la plage spécifiée par le constructeur. En effet, une opération indésirable, telle qu'une programmation, deviendrait possible ou bien une opération pourrait se fausser et conduire à une lecture erronée. Il est aussi possible que les sécurités prévues sur le circuit perdent leur efficacité, de sorte que des fraudes deviennent possibles.

Il a donc été prévu d'incorporer dans le circuit intégré un circuit de détection de dépassement de seuils de tension. Le brevet US 3,733,498 divulgue un circuit de détection de dépassement de seuils, comportant deux branches, chacune comportant une diode et un générateur de courant commandé en tension par le point milieu de l'autre branche, ainsi que deux étages de sortie ayant une entrée connectée au point milieu d'une branche, la sortie de l'étage de sortie constituant une sortie du circuit de détection de dépassement de seuils. De tels circuits sont aussi connus qui utilisent des diviseurs résistifs pour permettre de détecter un excès de tension (dépassement de seuil haut) ou un défaut de tension (dépassement de seuil bas).

Pourtant ces circuits de détection antérieurs souffrent d'une variation importante du seuil de détection sous l'effet de la température ambiante du circuit intégré auquel ils sont incorporés. Il arrive aussi souvent que le seuil de détection varie avec le procédé de fabrication, auquel cas le seuil de détection variera d'un circuit de détection à l'autre, bien que pour les mêmes conditions de fonctionnement. C'est ainsi que pour une tension d'entrée nominale de 5 volts, les circuits antérieurs à l'invention permettent de détecter au mieux un seuil de 4 volts à plus, ou moins, 1 volt. En fait, les circuits de détection connus n'appartiennent qu'à des circuits intégrés classiques, mais ne répondent pas aux spécifications exigeantes des circuits sécurisés.

L'invention consiste en un circuit de détection comportant deux branches incluant chacune un générateur de courant commandé en tension constante par l'autre branche. Chaque branche comprend en outre au moins une diode polarisée en direct, le circuit ainsi obtenu étant effectif pour maintenir un courant constant dans chacune des branches, ce qui a pour effet de reporter la variation de tension existant sur une branche à un point déterminé de celle-ci. Un étage de sortie est connecté en entrée à l'une et l'autre des branches et il est calibré de manière à permettre de détecter un dépassement minimum d'un seuil de tension donné. L'étage de sortie fournit une réponse binaire (zéro, ou un) indiquant si la position de la tension d'alimentation par rapport à ce seuil est en excès ou en défaut.

Ce circuit, grâce à son principe de réaction entre deux branches permet avantageusement de déceler des seuils de tension avec une grande précision.

Le circuit de détection de dépassement de seuils par une tension d'alimentation, selon l'invention, est défini par les caractéristiques de la revendication 1.

D'autres caractéristiques et avantages de l'invention sont décrits dans la description détaillée qui suit faite en référence aux dessins annexés dans lesquels :
- la figure 1 représente un schéma de principe de l'invention et
- la figure 2 représente un mode de réalisation préféré de l'invention.

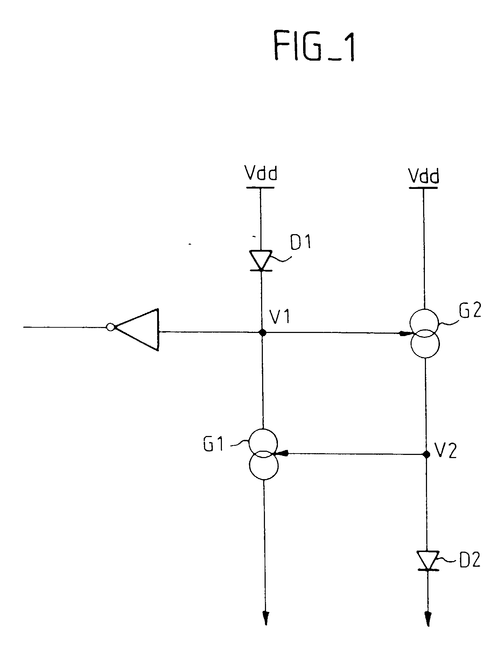

La figure 1 représente le principe de l'invention. On notera que dans la suite, tous les potentiels sont référencés par rapport à la masse. Le circuit électronique comprend trois blocs :
- un étage de sortie,
- une première branche comprenant une diode D1 dont l'anode est connectée à la tension d'alimentation à surveiller Vdd et un générateur de courant G1 connecté entre la cathode de la diode et la masse,
- une deuxième branche comprenant un générateur de courant G2 connecté entre la tension Vdd et l'anode d'une diode D2 dont la cathode est reliée à la masse.

On appelle point milieu d'une branche, le point de connexion entre la diode et le générateur de courant de cette même branche, de sorte que V1 est le point milieu de la première branche et V2 le point milieu de la deuxième. Le générateur de courant G1 est commandé en tension par le point milieu de la deuxième branche. Le générateur de courant G2 est commandé en tension par le point milieu de la première branche. L'entrée de l'étage de sortie est connectée au point milieu V1. La sortie de l'étage de sortie sert à délivrer l'information de dépassement du seuil que l'on veut détecter. L'étage de sortie peut être une porte logique telle qu'une porte NOR ou une porte NAND, ou bien, et de préférence, comme retenu dans la suite de la description, l'étage de sortie est un inverseur.

Le circuit de détection de seuils selon l'invention opère comme suit : lorsque le circuit est équilibré, la diode de chacune des branches est polarisée à un potentiel constant par le courant constant délivré par le générateur de courant propre de la branche. Si la tension d'alimentation Vdd varie, par exemple si Vdd baisse, la diode D1 de la première branche étant polarisée à courant constant, cette variation de tension due à Vdd se trouvera reportée dans la première branche entre le point milieu V1 et la masse. Autrement dit, le point milieu V1 suivra les variations de la tension d'alimentation Vdd. D'autre part, ce point milieu V1 commande en tension le générateur de courant G2 de la deuxième branche. La différence de potentiel entre V1 et Vdd est donc constante puisque V1 varie comme Vdd. Il s'ensuit que le générateur de courant G2 fournira un courant constant, ce, indépendamment de la variation de la tension d'alimentation Vdd. Par conséquent, le point milieu V2 sera à un potentiel constant ne variant pas avec Vdd. Le point milieu V2 alimente en tension le générateur de courant G1, ce qui fournit un courant constant dans la première branche. Le point milieu V1 qui répond à la variation de la tension d'alimentation Vdd commande l'entrée d'un inverseur qui est calibré pour basculer pour une valeur de potentiel critique particulière (figure 1).

Si on prévoit un inverseur en sortie du point milieu V2, puisque dans ce cas le potentiel V2 comme on l'a vu sera constant et donc indépendant des variations de la tension d'alimentation Vdd, l'inverseur aura comme référence la tension d'alimentation Vdd, et c'est la différence de potentiel entre la tension d'alimentation Vdd et le potentiel au point milieu V2 qui dans ce cas, commandera le basculement de l'inverseur.

Le circuit selon l'invention permet la détection de deux seuils. Pour cela, on aura un étage de sortie calibré pour un certain seuil et connecté sur V1 et un second étage de sortie calibré pour un autre seuil et connecté sur V2.

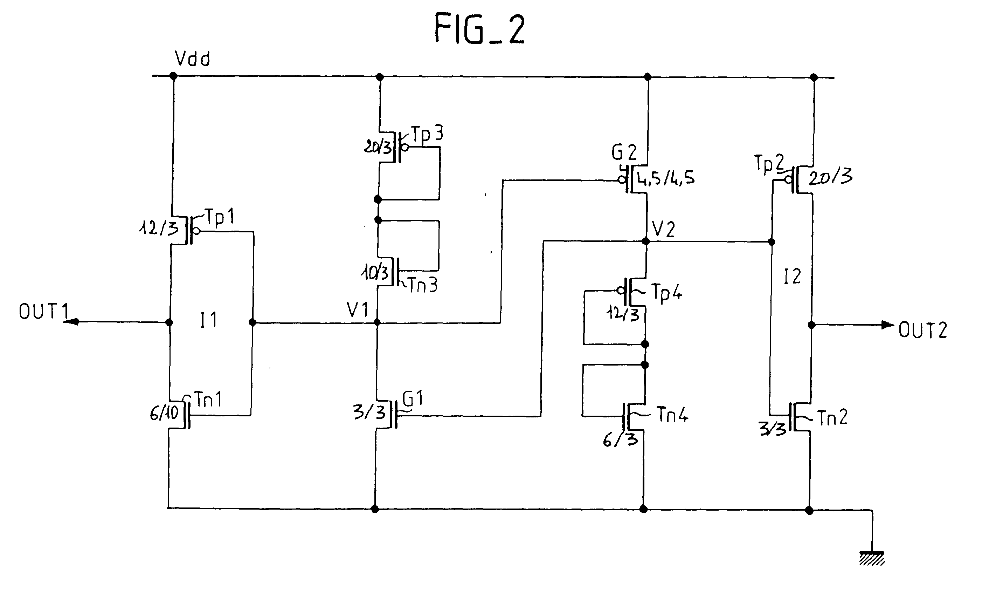

Un mode préféré de réalisation est représenté sur la figure 2. Dans la première branche, le générateur de courant G1 est de préférence un transistor de type N dont le drain est connecté au point milieu V1 et la source connectée à la masse. Avantageusement, il est polarisé en saturation. La diode D1 est réalisée avec deux transistors mis en série, l'un de type P Tp3 et le deuxième de type N Tn3. Ces deux transistors sont montés en diode polarisée en direct. Ainsi la source du transistor Tp3 est reliée à Vdd et la source du transistor Tn3 est reliée à V1. La grille et le drain de chacun de ces transistors sont reliés ensemble. Le drain du transistor Tp3 est par ailleurs relié au drain du transistor Tn3.

Pour la deuxième branche, le générateur de courant G2 est de préférence un transistor de type P dont la source est reliée à Vdd et le drain au point milieu V2. Il est de préférence polarisé en saturation. La diode D2 est de préférence réalisée par deux transistors, l'un de type P Tp4, l'autre de type N Tn4. Tous deux sont montés en diode polarisée en direct. Ainsi la source du transistor Tp4 est reliée au point milieu V2 et la source du transistor Tn4 est reliée à la masse. Le drain et la grille de chaque transistor sont reliés ensemble. Le drain du transistor Tn4 est relié au drain du transistor Tp4.

Un premier inverseur I1 a son entrée connectée au point milieu V1. Dans l'exemple de la figure 2 , c'est un inverseur CMOS comprenant un transistor de type P Tp1 et un transistor de type N Tn1. De manière connue, les drains des transistors Tp1 et Tn1 sont reliés ensemble et forment la sortie OUT1 de l'inverseur I1. Les grilles des transistors Tp1 et Tn1 sont reliées ensemble et forment l'entrée de l'inverseur qui est connectée au point milieu V1. La source du transistor Tp1 est reliée à Vdd tandis que la source du transistor Tn1 est reliée à la masse. De même, un deuxième inverseur I2 a son entrée connectée au point milieu V2. Comme le montre la figure 2, c'est un inverseur CMOS comprenant un transistor P Tp2 et un transistor N Tn2. De manière connue, les drains des transistors Tp2 et Tn2 sont reliés ensemble et forment la sortie OUT2 de l'inverseur I2. Les grilles des transistors Tp2 et Tn2 sont reliées ensemble et forment l'entrée de l'inverseur qui est connectée au point milieu V2. Enfin, la source du transistor Tp2 est reliée à Vdd et la source du transistor Tn2 est reliée à la masse.

Par exemple, l'inverseur I1 sera calibré pour détecter un niveau bas de la tension d'alimentation Vdd et l'inverseur I2 le sera pour détecter un niveau haut de cette même tension. Les dimensions des transistors des deux inverseurs seront choisies pour pouvoir détecter les seuils désirés.

Si l'inverseur I1 doit détecter un seuil bas, le point milieu V1 va suivre les variations de la tension de l'alimentation Vdd, tandis que la différence de potentiel entre la grille et la source du transistor Tp1 de l'inverseur I1 ne varie pas. Il faut donc, pour que l'inverseur bascule, que le transistor Tn1 soit conducteur ou bloqué selon la différence de potentiel existant entre sa grille et sa source, c'est à dire selon la valeur du potentiel du point milieu V1. Donc, tant que Vdd ne baisse pas en dessous du seuil bas, le transistor Tn1 sera conducteur. L'inverseur I1 est alors tel que OUT1 est à zéro. Lorsque la tension Vdd baisse en dessous du seuil bas (dépassement par défaut), le potentiel du point milieu V1 baisse en dessous du seuil de conduction du transistor Tn1 de l'inverseur I1. Alors, le transistor Tn1 se bloque, l'inverseur I1 bascule et la sortie de l'inverseur passe à 1.

Pour l'inverseur I2, les conditions sont différentes, puisqu'il faut détecter un seuil haut d'alimentation, alors que, selon la figure 2, le potentiel de l'entrée de l'inverseur est constant. La variable est donc la tension d'alimentation Vdd.

Le transistor Tp2 de l'inverseur I2 a sa source reliée à Vdd et sa grille reliée au point milieu V2. La tension V2 est constante. La différence de potentiel entre la source et la grille du transistor Tp2 varie donc avec Vdd. Le transistor Tn2 a sa grille connectée au point milieu V2 et sa source connectée à la masse. La différence de potentiel entre la source et la grille du transistor Tn2 est donc constante. Faire basculer l'inverseur I2 dépendra donc de l'état du transistor Tp2. Comme on veut détecter un seuil haut d'alimentation, on calibrera l'inverseur pour que pour une tension Vdd en dessous du seuil haut d'alimentation, le potentiel V2 soit supérieur à la différence de potentiel entre Vdd et le seuil de conduction du transistor Tp2. Si c'est le cas, le transistor Tp2 est bloqué et la sortie de l'inverseur I2 est à 0. Si la tension Vdd augmente au dessus du seuil haut, la différence de potentiel entre Vdd et V2 augmente et le seuil de conduction du transistor Tp2 est franchi. L'inverseur I2 bascule : le transistor Tp2 conduit et la sortie OUT2 de l'inverseur I2 passe à 1.

On peut aussi bien choisir que l'inverseur I1 détecte un seuil haut et que l'inverseur I2 détecte un seuil bas. On calibrera alors les inverseurs selon la logique de fonctionnement désiré.

C'est donc grâce au fait que l'on peut maintenir un courant constant dans chacune des branches que l'on aura ainsi une détection stable des seuils de tension d'alimentation.

De préférence et comme décrit précédemment, la diode D1 est réalisée par deux transistors de types de conduction opposés. On sait en effet que les caractéristiques des transistors, et notamment leur seuil de conduction, varient avec les procédés de fabrication et avec la température. On sait aussi que ces variations sont contraires dans un transistor P et dans un transistor N. Ainsi, pour obtenir une meilleure compensation thermique et de variation de procédés, il est préférable d'utiliser deux transistors de types opposés mis en série pour réaliser la diode D1. Il s'ensuit que le potentiel V1 suivra plus fidèlement les variations de Vdd. On est également assuré que le potentiel V2 va restera aussi constant que possible.

Le réglage du niveau de détection se fait en pratique grâce à l'ajustement des générateurs de courant pour polariser correctement les diodes de chacune des branches compte tenu des dimensions des transistors des inverseurs permettant d'ajuster le seuil de basculement à des potentiels V1, V2 définis. Les générateurs de courant et les dimensions des transistors des inverseurs se déterminent selon des méthodes habituelles, en fonction du niveau de la tension à surveiller et des seuils bas et/ou haut à détecter.

Le principe de l'invention et son mode de réalisation préféré permettent une détection très fiable, ce qui est confirmé par des simulations montrant par exemple que pour une tension d'alimentation Vdd de 5 volts, un seuil haut de 5,5 volts et un seuil bas de 4,5 volts, on arrive en sortie à détecter des seuils à plus ou moins 0,35 volts, ce, dans une plage de fonctionnement en température de -40 à +80°C et dans la fenêtre de variation des tensions de seuil dépendant du procédé de fabrication. Ceci est bien supérieur aux solutions actuelles qui présentent des variations de l'ordre de plus ou moins 1 volt au minimum. C'est une nette amélioration qui permet une meilleure protection des circuits sécurisés. Des variantes sont possibles. Ainsi, on peut n'utiliser qu'un seul transistor pour réaliser la diode de chacune des branches, mais on perd alors un élément favorable en ce qui concerne la précision. Par ailleurs, il est aussi possible d'inverser les transistors N et P dans chacune des branches. Toutes ces variantes appartiennent au domaine de l'invention.

## Revendications

1. Circuit de détection de dépassement de seuils par une tension d'entrée (Vdd), comportant une première branche comprenant une diode (D1) polarisée en direct entre la tension d'entrée et un point milieu (V1) et un générateur de courant (G1) entre le point milieu et la masse, une deuxième branche comprenant un générateur de courant (G2) entre la tension d'entrée et un point milieu (V2) et une diode (D2) polarisée en direct entre le point milieu et la masse, le générateur de courant (G1) d'une branche étant commandé en tension par le point milieu (V2) de l'autre branche, comprenant en outre un étage de sortie (I1, I2) constitué par un inverseur pour chaque branche, dont l'entrée est connectée au point milieu (V1) de la branche correspondante, les deux étages de sortie étant alimentés entre la tension d'entrée (Vdd) et la masse et étant respectivement calibrés pour un premier et un deuxième seuil, de manière à délivrer une information (OUT1, OUT2) indiquant si la tension d'entrée est comprise dans l'intervalle ainsi déterminé.

2. Circuit de détection selon la revendication 1, caractérisé en ce que la diode (D1, D2) d'une branche est constituée par deux transistors de type opposé en série (Tp3, Tn3, Tp4, Tn4), chacun ayant sa grille reliée à son drain.

3. Circuit de détection selon la revendication 1 ou 2, caractérisé en ce que le générateur de courant (G1, G2) d'une branche est un transistor polarisé à une tension grille source constante.

4. Circuit de détection selon la revendication 3, caractérisé en ce que la grille du transistor formant le générateur de courant (G1, G2) d'une branche est connectée au point milieu (V2, V1) de l'autre branche.

5. Circuit de détection selon l'une quelconque des revendications précédentes, caractérisé en ce qu'il est incorporé dans une puce de circuit intégré et qu'il comporte au moins une sortie apte à inhiber le fonctionnement d'autres circuits placés sur la même puce de circuit intégré en cas de détection d'un dépassement de seuil de tension par la tension d'entrée du circuit.

6. Circuit de détection selon l'une quelconque des revendications précédentes, caractérisé en ce qu'il comporte deux sorties (OUT1, OUT2) aptes à inhiber chacune le fonctionnement d'autres circuits placés sur la même puce de circuit intégré lors d'une détection d'un dépassement d'un seuil de tension par la tension d'entrée du circuit.

## Patentansprüche

1. Schaltkreis zum Erfassen des Überschreitens von Schwellen durch eine Eingangsspannung (Vdd), der einen ersten Zweig mit einer Diode (D1), die zwischen der Eingangsspannung und einem Mittelpunkt (V1) in Vorwärtsrichtung betrieben wird, und einen Stromgenerator (G1) zwischen dem Mittelpunkt und Masse, einen zweiten Zweig mit einem Stromgenerator (G2) zwischen der Eingangsspannung und einem Mittelpunkt (V2) und einer Diode (D2), die zwischen dem Mittelpunkt und Masse in Vorwärtsrichtung betrieben wird, umfaßt, wobei der Stromgenerator (G1) eines Zweiges von dem Mittelpunkt (V2) des anderen Zweiges spannungsgesteuert wird, und außerdem eine Ausgangsstufe (I1, I2) umfaßt, die einen Inverter für jeden Zweig aufweist, dessen Eingang mit dem Mittelpunkt (V1) des entsprechenden Zweiges verbunden ist, wobei die zwei Ausgangsstufen mit Eingangsspannung (Vdd) und Masse versorgt werden und jeweils so eingestellt sind, daß sie eine erste und eine zweite Schwelle erfassen, um eine Information (OUT1, OUT2) auszugeben, die anzeigt, ob die Eingangsspannung sich innerhalb des so festgelegten Intervalls befindet.

2. Schaltkreis zum Erfassen nach Anspruch 1, dadurch gekennzeichnet, daß die Diode (D1, D2) eines Zweiges aus zwei Transistoren von entgegengesetztem Typ in Reihe (Tp3, Tn3, Tp4, Tn4) besteht, wobei bei jedem das Gate mit dem Drain verbunden ist.

3. Schaltkreis zum Erfassen nach Anspruch 1 oder 2, dadurch gekennzeichnet, daß der Stromgenerator (G1, G2) eines Zweiges ein Transistor ist, der mit einer Spannung Gate-Source vorgespannt wird, die konstant ist.

4. Schaltkreis zum Erfassen nach Anspruch 3, dadurch gekennzeichnet, daß das Gate des Transistors, der den Stromgenerator (G1, G2) eines Zweiges bildet, mit dem Mittelpunkt (V2, V1) des anderen Zweiges verbunden ist.

5. Schaltkreis zum Erfassen nach einem der vorangehenden Ansprüche, dadurch gekennzeichnet, daß er in einem Chip eines integrierten Schaltkreises eingebaut ist und wenigstens einen Ausgang aufweist, der dazu dient, die Funktion von anderen Schaltkreisen auf demselben Chip des integrierten Schaltkreises im Fall des Erfassens eines Überschreitens der Schwellenspannung durch die Spannung am Eingang des Schaltkreises zu unterbinden.

6. Schaltkreis zum Erfassen nach einem der vorangehenden Ansprüche, dadurch gekennzeichnet, daß er zwei Ausgänge (OUT1, OUT2) aufweist, die dazu geeignet sind, jeweils die Funktion anderer Schaltkreise zu unterbinden, die sich auf demselben Chip des integrierten Schaltkreises befinden, wenn ein Überschreiten einer Schwellenspannung durch die Spannung am Eingang des Schaltkreises erfaßt wird.

## Claims

1. A circuit for detecting out-of-limits condition by an input voltage (Vdd), comprising a first leg comprising a diode (D1) directly biased between the input voltage and a middle point (VI) and a current generator (G1) between the middle point and the earth, a second leg comprising a current generator (G2) between the input voltage and a middle point (V2) and a diode (D2) directly biased between the middle point and the earth, the current generator (G1) of one leg being controlled with respect to voltage by the middle point (V2) of the other leg, also comprising an output stage (I1, I2) formed by an inverter for each leg, the input of which is connected to the middle point (V1) of the corresponding leg, the two output stages being supplied between the input voltage (Vdd) and the earth and being respectively calibrated for a first and a second limit, so as to supply information (OUT1, OUT2) indicating if the input voltage falls within the interval thus determined.

2. A detection circuit according to Claim 1,
**characterised in that** the diode (D1, D2) of one leg formed by two transistors of opposite types in series (Tp3, Tn3, Tp4, Tn4), each having its gate connected to its drain.

3. A detection circuit according to Claim 1 or 2,
**characterised in that** the current generator (G1, G2) of one leg is a transistor biased at a constant gate-source voltage.

4. A detection circuit according to Claim 3,
**characterised in that** the gate of the transistor forming the current generator (G1, G2) of one leg is connected to the middle point (V2, V1) of the other leg.

5. A detection circuit according to any one of the preceding Claims,
**characterised in that** it is incorporated in an integrated circuit chip,
**and in that** it comprises at least one output capable of inhibiting the operation of other circuits placed on the same integrated circuit chip in the event of the detection of a voltage limit being exceeded by the input voltage of the circuit.

6. A detection circuit according to any one of the preceding Claims,
**characterised in that** it comprises two outputs (OUT1, OUT2) each capable of inhibiting the operation of other circuits placed on the same integrated circuit chip during the detection of a voltage limit being exceeded by the input voltage of the circuit.
